# EUROPEAN PATENT APPLICATION

(11) **EP 4 012 784 A1**
(43) Date of publication of application: **15.06.2022**
(21) Application number: 21195455.7
(22) Date of filing: 08.09.2021
(51) Int. Cl.: H01L 29/786, H01L 29/10

(54) **TRANSISTOR CHANNEL MATERIALS**

(30) Priority: 14.12.2020 US 202017121313
(71) Applicant: Intel Corporation, Santa Clara, CA 95054 (US)
(72) Inventor: Sharma, Abhishek A., Hillsboro 97124 (US); Sato, Noriyuki, Hillsboro 97124 (US); Le, Van H., Beaverton 97007 (US); Atanasov, Sarah, Beaverton 97003 (US); Sen Gupta, Amab, Beaverton 97003 (US); Metz, Matthew V., Portland 97229 (US); Yoo, Hui Jae, Hillsboro 97124 (US)
(74) Representative: Goddar, Heinz J.

(57) **Abstract**

Disclosed herein are transistor channel materials, and related methods and devices. For example, in some embodiments, a transistor may include a channel material including a semiconductor material having a first conductivity type, and the channel material may further include a dopant including (1) an insulating material and/or (2) a material having a second conductivity type opposite to the first conductivity type.

## Description

### Background

Thin-film transistors may include a gate oxide between a gate electrode and a semiconducting channel. The gate oxide may be, for example, a high-k dielectric material.

### Brief Description of the Drawings

Embodiments will be readily understood by the following detailed description in conjunction with the accompanying drawings. To facilitate this description, like reference numerals designate like structural elements. Embodiments are illustrated by way of example, not by way of limitation, in the figures of the accompanying drawings.
FIG. 1 is a cross-sectional side view of a transistor gate-channel arrangement including a doped channel material, in accordance with various embodiments.
FIGS. 2-6 are cross-sectional side views of example single-gate transistors including a doped channel material, in accordance with various embodiments.
FIGS. 7-9 are cross-sectional side views of example double-gate transistors including a doped channel material, in accordance with various embodiments.
FIGS. 10A and 10B are perspective and cross-sectional side views, respectively, of an example tri-gate transistor including a doped channel material, in accordance with various embodiments.
FIGS. 11A and 11B are perspective and cross-sectional side views, respectively, of an example all-around gate transistor including a doped channel material, in accordance with various embodiments.
FIG. 12 is a flow diagram of an example method of manufacturing an integrated circuit (IC) structure including a doped channel material, in accordance with various embodiments.
FIGS. 13A and 13B are top views of a wafer and dies that include one or more doped channel materials in accordance with any of the embodiments disclosed herein.
FIG. 14 is a cross-sectional side view of an IC device that may include one or more doped channel materials in accordance with any of the embodiments disclosed herein.
FIG. 15 is a cross-sectional side view of an IC device assembly that may include one or more doped channel materials in accordance with any of the embodiments disclosed herein.
FIG. 16 is a block diagram of an example computing device that may include one or more doped channel materials in accordance with any of the embodiments disclosed herein.

### Detailed Description

Disclosed herein are transistor channel materials, and related methods and devices. For example, in some embodiments, a transistor may include a channel material including a semiconductor material having a first conductivity type, and the channel material may further include a dopant including (1) an insulating material and/or (2) a material having a second conductivity type opposite to the first conductivity type. The doped channel materials disclosed herein may decrease a transistor's susceptibility to degradation during the temperatures required for back-end processing, and thus may enable higher quality back-end thin-film transistors than are achievable using conventional approaches.

In the following detailed description, reference is made to the accompanying drawings that form a part hereof, and in which is shown, by way of illustration, embodiments that may be practiced. It is to be understood that other embodiments may be utilized and structural or logical changes may be made without departing from the scope of the present disclosure. Therefore, the following detailed description is not to be taken in a limiting sense.

Various operations may be described as multiple discrete actions or operations in turn, in a manner that is most helpful in understanding the claimed subject matter. However, the order of description should not be construed as to imply that these operations are necessarily order dependent. In particular, these operations may not be performed in the order of presentation. Operations described may be performed in a different order from the described embodiment. Various additional operations may be performed, and/or described operations may be omitted in additional embodiments.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges.

The description uses the phrases "in an embodiment" or "in embodiments," which may each refer to one or more of the same or different embodiments. Furthermore, the terms "comprising," "including," "having," and the like, as used with respect to embodiments of the present disclosure, are synonymous. The disclosure may use perspective-based descriptions such as "above," "below," "top," "bottom," and "side"; such descriptions are used to facilitate the discussion and are not intended to restrict the application of disclosed embodiments. The accompanying drawings are not necessarily drawn to scale. As used herein, a "high-k dielectric" refers to a material having a higher dielectric constant than silicon oxide. As used herein, a "conductivity type" refers to the p-type or n-type conductivity of a material.

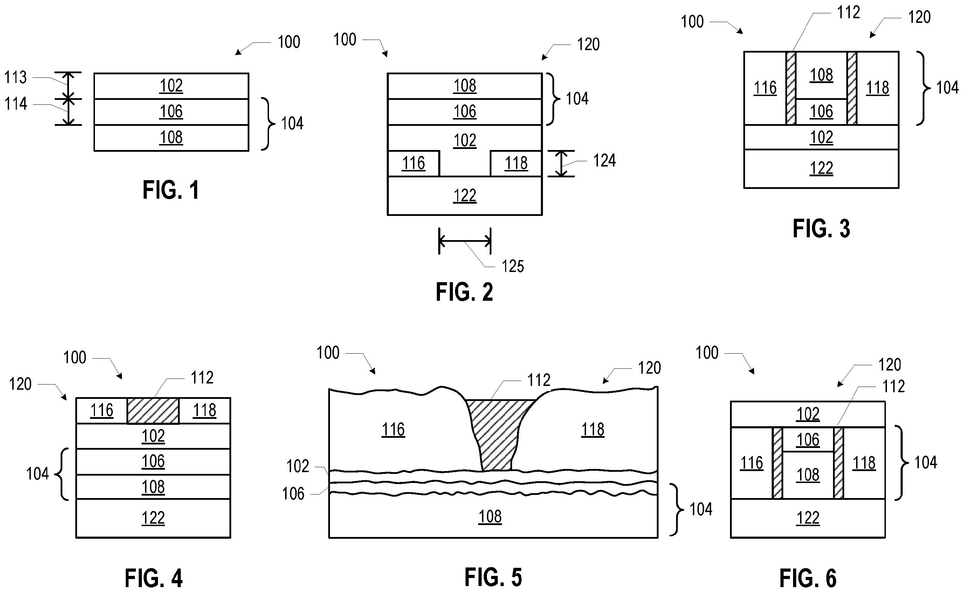

FIG. 1 is a cross-sectional side view of an integrated circuit (IC) structure 100 including a doped channel material 102 and a transistor gate stack 104 (also referred to as a "gate stack 104" herein), in accordance with various embodiments. The transistor gate stack 104 may include a gate electrode material 108, and a gate dielectric 106 disposed between the gate electrode material 108 and the doped channel material 102.

The doped channel material 102 may include one or more semiconductor materials and one or more dopants. In some embodiments, the doped channel material 102 may include a semiconductor material, and the dopant may include an insulating material. For example, the semiconductor material of a doped channel material 102 may include a group IV semiconductor (e.g., silicon and/or germanium), a group lll-V semiconductor (e.g., gallium and nitrogen in the form of gallium nitride, or gallium and arsenic in the form of gallium arsenide), or an oxide semiconductor (e.g., indium, zinc, and oxygen in the form of indium zinc oxide; indium, gallium, zinc, and oxygen in the form of indium gallium zinc oxide (IGZO); indium, tin, and oxygen in the form of indium tin oxide (ITO); indium and oxygen in the form of indium oxide; zinc and oxygen in the form of zinc oxide; tin and oxygen in the form of tin oxide; or copper and oxygen in the form of copper oxide). The insulating material of a doped channel material 102 may include aluminum and oxygen (e.g., in the form of aluminum oxide); hafnium and oxygen (e.g., in the form of hafnium oxide); titanium and oxygen (e.g., in the form of titanium oxide); aluminum and nitrogen (e.g., in the form of aluminum nitride); silicon and nitrogen (e.g., in the form of silicon nitride); silicon and oxygen (e.g., in the form of silicon oxide); silicon, carbon, oxygen, and hydrogen (e.g., in the form of organosilicate glass); tantalum and oxygen (e.g., in the form of tantalum oxide); yttrium and oxygen (e.g., in the form of yttrium oxide); gallium and oxygen (e.g., in the form of gallium oxide); zirconium and oxygen (e.g., in the form of zirconium oxide); hafnium, zirconium, and oxygen (e.g., in the form of hafnium zirconium oxide); yttrium, zirconium, and oxygen (e.g., in the form of yttrium zirconium oxide); magnesium and oxygen (e.g., in the form of magnesium oxide); or carbon. In some embodiments in which a doped channel material 102 includes a semiconductor material and an insulating material dopant, the dopant may be present at a concentration that is less than 10 atomic-percent. Including a semiconductor material and an insulating material dopant in the doped channel material 102 may increase the threshold voltage of an associated transistor (e.g., any of the transistors 120 discussed herein) at the expense of a lower drive current.

In some embodiments, the doped channel material 102 may include a semiconductor material having a first conductivity type, and a dopant that has a second conductivity type opposite to the first conductivity type. For example, the semiconductor material may have an n-type conductivity while the dopant has a p-type conductivity (or vice versa). In some such embodiments, the semiconductor material may be an oxide semiconductor; for example, the semiconductor material may include indium, gallium, zinc, and oxygen (e.g., in the form of IGZO); indium, tin, and oxygen (e.g., in the form of ITO); indium and oxygen (e.g., in the form of indium oxide); or zinc and oxygen (e.g., in the form of zinc oxide). These oxide semiconductors may have n-type conductivity, and a dopant having p-type conductivity may include copper and oxygen (e.g., in the form of copper oxide); tin and oxygen (e.g., in the form of tin oxide); niobium and oxygen (e.g., in the form of niobium oxide); nickel and oxygen (e.g., in the form of nickel oxide); or cobalt and oxygen (e.g., in the form of cobalt oxide). P-type oxide semiconductors, which may include copper and oxygen (e.g., in the form of copper oxide), tin and oxygen (e.g., in the form of tin oxide), or copper and tin and oxygen (e.g., in the form of copper tin oxide), for example, may include a dopant having n-type conductivity (such as any of the n-type materials discussed above). In some embodiments in which a doped channel material 102 includes a semiconductor material and an opposite conductivity type dopant, the dopant may be present at a concentration that is less than 10 atomic-percent. Including a semiconductor material and an opposite conductivity type dopant in the doped channel material 102 may increase the drive current of an associated transistor (e.g., any of the transistors 120 discussed herein) at the expense of a lower threshold voltage.

In some embodiments, a doped channel material 102 may include both an insulating material dopant and an opposite conductivity type dopant. For example, in some embodiments, a doped channel material 102 may include alternating layers of a semiconductor material doped with an insulating material (e.g., in accordance with any of the embodiments disclosed herein) and layers of a semiconductor material with a dopant of opposite conductivity type (e.g., in accordance with any of the embodiments disclosed herein). Such embodiments may combine the drive current/threshold voltage advantages and disadvantages of the individual layers to achieve a desired overall performance.

The gate electrode material 108 may include at least one p-type work function metal or n-type work function metal, depending on whether the transistor gate stack 104 is to be included in a p-type metal oxide semiconductor (PMOS) transistor or an n-type metal oxide semiconductor (NMOS) transistor (e.g., any of the transistors 120 discussed below). For a PMOS transistor, metals that may be used for the gate electrode material 108 may include, but are not limited to, ruthenium, palladium, platinum, cobalt, nickel, and conductive metal oxides (e.g., ruthenium oxide). For an NMOS transistor, metals that may be used for the gate electrode material 108 include, but are not limited to, hafnium, zirconium, titanium, tantalum, aluminum, alloys of these metals, and carbides of these metals (e.g., hafnium carbide, zirconium carbide, titanium carbide, tantalum carbide, and aluminum carbide). In some embodiments, the gate electrode material 108 may consist of a stack of two or more metal layers, where one or more metal layers are work function metal layers and at least one metal layer is a fill metal layer. Further metal layers may be included for other purposes, such as to act as a barrier layer.

The gate dielectric 106 may include a high-k dielectric. The high-k dielectric may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric 106 may include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate.

The dimensions of the elements of an IC structure 100 may take any suitable values. For example, the doped channel material 102 may have a thickness 113. In some embodiments, the thickness 113 may be between 5 nanometers and 30 nanometers (e.g., between 2 nanometers and 10 nanometers). The gate dielectric 106 may have a thickness 114. In some embodiments, the thickness 114 may be between 0.5 nanometers and 3 nanometers (e.g., between 1 nanometer and 3 nanometers, or between 1 nanometer and 2 nanometers).

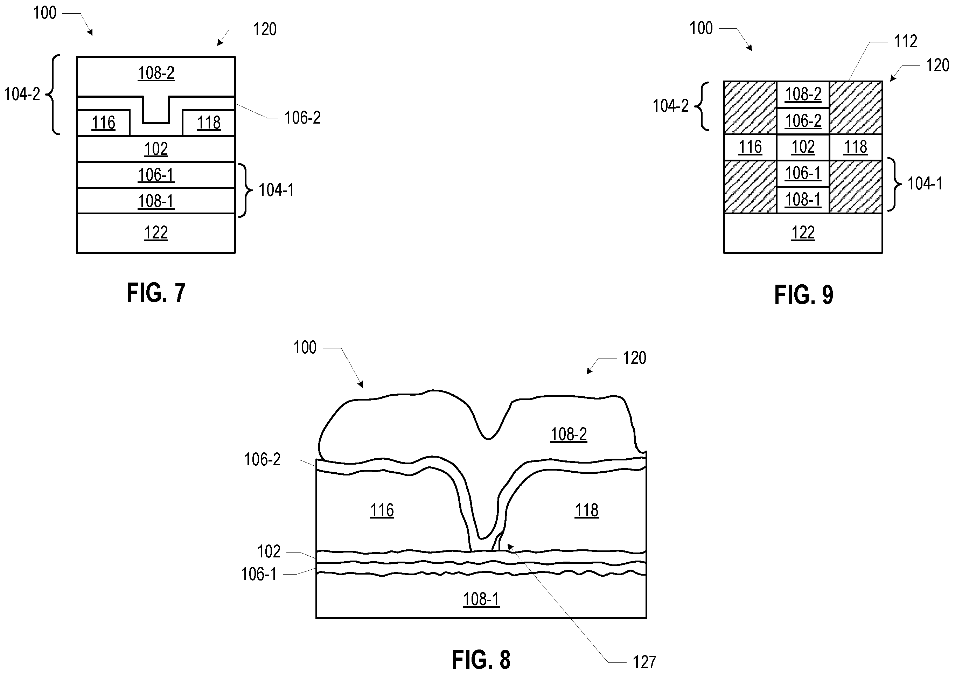

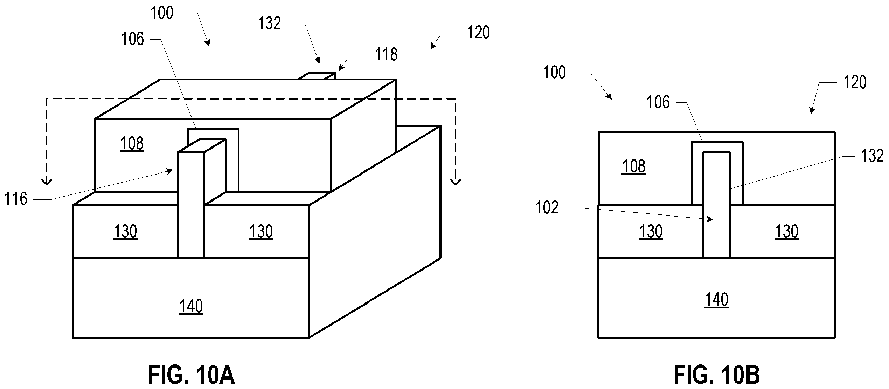

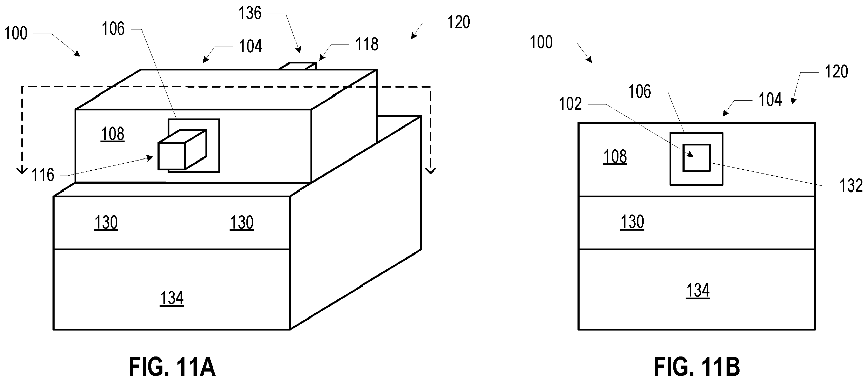

The doped channel material 102 may be included in any suitable transistor structure. For example, FIGS. 2-6 are cross-sectional side views of example single-gate transistors 120 including a doped channel material 102, FIGS. 7-9 are cross-sectional side views of example double-gate transistors 120 including a doped channel material 102, FIGS. 10A and 10B are perspective and cross-sectional side views, respectively, of an example tri-gate transistor 120 including a doped channel material 102, and FIGS. 11A and 11B are perspective and cross-sectional side views, respectively, of an example all-around gate transistor 120 including a doped channel material 102, in accordance with various embodiments. The transistors 120 illustrated in FIGS. 2-11 do not represent an exhaustive set of transistor structures in which a doped channel material 102 may be included, but provide examples of such structures. Note that FIGS. 2-6 are intended to show relative arrangements of the components therein, and the transistors 120 may include other components that are not illustrated (e.g., electrical contacts to the gate electrode materials 108, etc.). Any of the components of the transistors 120 discussed below with reference to FIGS. 2-11 may take the form of any of the embodiments of those components discussed above with reference to FIG. 1. Additionally, although various components of the transistors 120 are illustrated in FIGS. 2-11 as being planar rectangles or formed of rectangular solids, this is simply for ease of illustration, and embodiments of these transistors 120 may be curved, rounded, or otherwise irregularly shaped as dictated by the manufacturing processes used to fabricate the transistors 120. The transistors 120 of FIGS. 2-3 may be referred to as "top gate" transistors, while the transistors 120 of FIGS. 4-6 may be referred to as "bottom gate" transistors. Similarly, the transistors 120 of FIGS. 2 and 6 may be referred to as "bottom contact" transistors, while the transistors 120 of FIGS. 3-5 may be referred to as "top contact" transistors.

FIG. 2 depicts a transistor 120 including a doped channel material 102 and having a single "top" gate provided by the gate electrode material 108 and the gate dielectric 106. The gate dielectric 106 may be disposed between the gate electrode material 108 and the doped channel material 102. In the embodiment of FIG. 2, the gate stack 104 is shown as disposed above a support 122. The support 122 may be any structure on which the gate stack 104, or other elements of the transistor 120, is disposed. In some embodiments, the support 122 may include a semiconductor, such as silicon. In some embodiments, the support 122 may include an insulating layer, such as an oxide isolation layer. For example, in the embodiments of FIGS. 2 and 3, the support 122 may include a semiconductor material and an interlayer dielectric (ILD) disposed between the semiconductor material and the source/drain (S/D) contact 116, the doped channel material 102, and the S/D contact 118, to electrically isolate the semiconductor material of the support 122 from the S/D contact 116, the doped channel material 102, and the S/D contact 118 (and thereby mitigate the likelihood that a conductive pathway will form between the S/D contact 116 and the S/D contact 118 through the support 122) . Examples of ILDs that may be included in a support 122 in some embodiments may include silicon oxide, silicon nitride, aluminum oxide, and/or silicon oxynitride. Any suitable ones of the embodiments of the support 122 described with reference to FIG. 2 may be used for the supports 122 of others of the transistors 120 disclosed herein.

As noted above, the transistor 120 may include an S/D contact 116 and an S/D contact 118 disposed on the support 122, with the doped channel material 102 disposed between the S/D contact 116 and the S/D contact 118 so that at least some of the doped channel material 102 is coplanar with at least some of the S/D contact 116 and the S/D contact 118. The S/D contact 116 and the S/D contact 118 may have a thickness 124. In some embodiments, the thickness 124 may be less than the thickness 113 (as illustrated in FIG. 2, with the S/D contact 116 and the S/D contact 118 each disposed between some of the doped channel material 102 and the support 122), while in other embodiments, the thickness 124 may be equal to the thickness 113. In some embodiments, the doped channel material 102, the gate dielectric 106, and/or the gate electrode material 108 may conform around the S/D contact 116 and/or the S/D contact 118. The S/D contact 116 and the S/D contact 118 may be spaced apart by a distance 125 that is the gate length of the transistor 120. In some embodiments, the gate length may be between 20 nanometers and 30 nanometers (e.g., between 22 nanometers and 28 nanometers, or approximately 25 nanometers).

The S/D contact 116 and the S/D contact 118 may be formed using any suitable processes known in the art. For example, one or more layers of metal and/or metal alloys may be deposited or otherwise provided to form the S/D contact 116 and the S/D contact 118, as known for thin-film transistors based on semiconductor oxide systems. Any suitable ones of the embodiments of the S/D contact 116 and the S/D contact 118 described above may be used for any of the S/D contacts 116 and S/D contacts 118 described herein.

FIG. 3 depicts a transistor 120 including a doped channel material 102 and having a single "top" gate provided by the gate electrode material 108 and the gate dielectric 106. The gate dielectric 106 may be disposed between the gate electrode material 108 and the doped channel material 102. In the embodiment of FIG. 3, the gate stack 104 is shown as disposed above a support 122. The transistor 120 may include an S/D contact 116 and an S/D contact 118 disposed on the support 122. As discussed above, in some embodiments, the support 122 of FIG. 3 may include a semiconductor material and ILD disposed between the semiconductor material and the S/D contact 116, the doped channel material 102, and the S/D contact 118, to electrically isolate the semiconductor material of the support 122 from the S/D contact 116, the doped channel material 102, and the S/D contact 118. In some embodiments, the gate dielectric 106 and/or the gate electrode material 108 may conform around the S/D contact 116 and/or the S/D contact 118. An insulating material 112 may be disposed between the S/D contacts 116/118 and the gate stack 104; the insulating material 112 may include any suitable insulating material, such as any of the ILDs discussed herein. Insulating material 112 on a doped channel material 102 may include a passivation material (e.g., hafnium oxide, zirconium oxide, aluminum oxide, silicon oxide, silicon nitride, silicon carbide, silicon oxycarbide, silicon oxynitride, titanium oxide, copper oxide, tin oxide, or copper tin oxide) in contact with the doped channel material 102. In some embodiments, the doped channel material 102 may include a semiconductor material with an insulating material dopant and/or an opposite conductivity type dopant proximate to the passivation material, and another material (e.g., a non-doped semiconductor material) distal to the passivation material (e.g., so that the semiconductor material with an insulating material dopant and/or an opposite conductivity type dopant is between the non-doped semiconductor material and the insulating material 112).

FIG. 4 depicts a transistor 120 including a transistor gate stack 104 and having a single "bottom" gate provided by the gate electrode material 108 and the gate dielectric 106. The gate dielectric 106 may be disposed between the gate electrode material 108 and the doped channel material 102. In the embodiment of FIG. 4, the gate stack 104 is shown as disposed on a support 122 in an orientation "upside down" to the one illustrated in FIG. 2; that is, the gate electrode material 108 may be disposed between the support 122 and the doped channel material 102. The transistor 120 may include an S/D contact 116 and an S/D contact 118 disposed on the doped channel material 102 such that the S/D contact 116 and the S/D contact 118 are not coplanar with the doped channel material 102. An insulating material 112 may be disposed between the S/D contacts 116 and 118, above the doped channel material 102.

FIG. 5 depicts a transistor 120 having the structure of the transistor 120 of FIG. 4. In particular, the transistor 120 of FIG. 5 includes a transistor gate stack 104 and has a single "bottom" gate provided by the gate electrode material 108 and the gate dielectric 106. The transistor 120 of FIG. 5 may also include a support 122 (not shown) arranged so that the gate electrode material 108 is disposed between the support 122 and the gate dielectric 106. The transistor 120 may include an S/D contact 116 and an S/D contact 118 disposed on the channel 102 such that the S/D contact 116 and the S/D contact 118 are not coplanar with the doped channel material 102. Any suitable materials may be used to form the transistor 120 of FIG. 5, as discussed above. For example, the gate electrode material 108 may include titanium nitride, the gate dielectric 106 may include hafnium oxide, and the S/D contact 116 and the S/D contact 118 may include aluminum. The gate length of the transistor 120 of FIG. 5 may be approximately 25 nanometers.

FIG. 6 depicts a transistor 120 including a transistor gate stack 104 and having a single "bottom" gate provided by the gate electrode material 108 and the gate dielectric 106. The gate dielectric 106 may be disposed between the gate electrode material 108 and the doped channel material 102. In the embodiment of FIG. 6, the gate stack 104 is shown as disposed on a support 122 in an orientation "upside down" to the one illustrated in FIG. 2; that is, the gate electrode material 108 may be disposed between the support 122 and the doped channel material 102. The transistor 120 may include an S/D contact 116 and an S/D contact 118 disposed on the doped channel material 102 such that at least some of the S/D contact 116 and at least some of the S/D contact 118 are coplanar with at least some of the doped channel material 102. In some embodiments, the S/D contact 116 and the S/D contact 118 may each be disposed between some of the doped channel material 102 and the support 122, as illustrated in FIG. 6, while in other embodiments, the doped channel material 102 may not extend "above" the S/D contact 116 or the S/D contact 118. In some embodiments, the doped channel material 102 may conform around the S/D contact 116 and/or the S/D contact 118.

FIG. 7 depicts a double-gate transistor 120 including two transistor gate stacks 104-1 and 104-2 and having "bottom" and "top" gates provided by the gate electrode material 108-1/gate dielectric 106-1 and the gate electrode material 108-2/gate dielectric 106-2, respectively. Each gate dielectric 106 may be disposed between the corresponding gate electrode material 108 and the doped channel material 102. The transistor 120 may include an S/D contact 116 and an S/D contact 118 disposed proximate to the doped channel material 102. In the embodiment illustrated in FIG. 7, the S/D contact 116 and the S/D contact 118 are disposed on the doped channel material 102, and the gate dielectric 106-2 is disposed conformably around the S/D contact 116, the doped channel material 102, and the S/D contact 118. The gate electrode material 108-2 is disposed on the gate dielectric 106-2. In the embodiment of FIG. 7, at least some of the S/D contact 116 and at least some of the S/D contact 118 are coplanar with at least some of the gate dielectric 106-2.

FIG. 8 depicts a double-gate transistor 120 having the structure of the transistor 120 of FIG. 7. In particular, the transistor 120 of FIG. 8 includes two transistor gate stacks 104-1 and 104-2 and having "bottom" and "top" gates provided by the gate electrode material 108-1/gate dielectric 106-1 and the gate electrode material 108-2/gate dielectric 106-2, respectively. The transistor 120 of FIG. 8 may also include a support 122 (not shown) arranged so that the gate electrode material 108-1 is disposed between the support 122 and the gate dielectric 106. The transistor 120 may include an S/D contact 116 and an S/D contact 118 disposed on the doped channel material 102 such that the S/D contact 116 and the S/D contact 118 are not coplanar with the doped channel material 102. In the embodiment depicted in FIG. 8, the S/D contact 116 and the S/D contact 118 may be deposited on the doped channel material 102. During manufacture, a void 127 may be formed between the gate dielectric 106-2 and the doped channel material 102; while such voids 127 may reduce the performance of the transistor 120, the transistor 120 may still function adequately as long as adequate coupling between the gate dielectric 106-2 and the doped channel material 102 is achieved. Any suitable materials may be used to form the transistor 120 of FIG. 8, as discussed above. For example, the gate electrode material 108-1 may be titanium nitride, the gate dielectrics 106-1 and 106-2 may include hafnium oxide, the S/D contact 116 and the S/D contact 118 may include aluminum, and the gate electrode material 108-2 may include palladium. The gate length of the transistor 120 of FIG. 8 may be approximately 25 nanometers.

FIG. 9 depicts a double-gate transistor 120 including two transistor gate stacks 104-1 and 104-2 and having "bottom" and "top" gates provided by the gate electrode material 108-1/gate dielectric 106-1 and the gate electrode material 108-2/gate dielectric 106-2, respectively. Each gate dielectric 106 may be disposed between the corresponding gate electrode material 108 and the doped channel material 102. The transistor 120 may include an S/D contact 116 and an S/D contact 118 disposed proximate to the doped channel material 102. In the embodiment illustrated in FIG. 9, the S/D contact 116 and the S/D contact 118 are coplanar with the doped channel material 102, and disposed between the gate dielectrics 106-1 and 106-2. The relative arrangement of the S/D contact 116, the S/D contact 118, and the doped channel material 102 may take the form of any of the embodiments discussed above with reference to FIG. 2.

FIGS. 10A and 10B are perspective and cross-sectional side views, respectively, of an example tri-gate transistor 120 including a doped channel material 102, in accordance with various embodiments. The transistor 120 of FIGS. 10A and 10B may include a doped channel material 102, and a gate stack 104 including a gate electrode material 108 and a gate dielectric 106. In the tri-gate transistor 120 illustrated in FIGS. 10A and 10B, a fin 132 formed of a semiconductor material may extend from a base 140 of the semiconductor material. An oxide material 130 may be disposed on either side of the fin 132. In some embodiments, the oxide material 130 may include a shallow trench isolation (STI) material.

The gate stack 104 may wrap around the fin 132 as shown, with the doped channel material 102 corresponding to the portion of the fin 132 wrapped by the gate stack 104. The fin 132 may include an S/D contact 116 and an S/D contact 118 on either side of the gate stack 104, as shown. The composition of the doped channel material 102, the S/D contact 116, and the S/D contact 118 may take the form of any of the embodiments disclosed herein, or known in the art. Although the fin 132 illustrated in FIGS. 10A and 10B is shown as having a rectangular cross section, the fin 132 may instead have a cross section that is rounded or sloped at the "top" of the fin 132, and the gate stack 104 may conform to this rounded or sloped fin 132. In use, the tri-gate transistor 120 may form conducting channels on three "sides" of the fin 132, potentially improving performance relative to single-gate transistors (which may form conducting channels on one "side" of the doped channel material 102) and double-gate transistors (which may form conducting channels on two "sides" of the doped channel material 102).

FIGS. 11A and 11B are perspective and cross-sectional side views, respectively, of an example all-around gate transistor 120 including a doped channel material 102, in accordance with various embodiments. The transistor 120 of FIGS. 11A and 11B may include a doped channel material 102, and a gate stack 104 including a gate electrode material 108 and a gate dielectric 106. In the all-around gate transistor 120 illustrated in FIGS. 11A and 11B, a wire 136 formed of a semiconductor material may extend above a support 134 and a layer of oxide material 130. The wire 136 may take the form of a nanowire or nanoribbon, for example. The gate stack 104 may wrap entirely or almost entirely around the wire 136, as shown, with the doped channel material 102 corresponding to the portion of the wire 136 wrapped by the gate stack 104. In some embodiments, the gate stack 104 may fully encircle the wire 136. The wire 136 may include an S/D contact 116 and an S/D contact 118 on either side of the gate stack 104, as shown. The composition of the doped channel material 102, the S/D contact 116, and the S/D contact 118 may take the form of any of the embodiments disclosed herein, or known in the art. Although the wire 136 illustrated in FIGS. 11A and 11B is shown as having a rectangular cross section, the wire 136 may instead have a cross section that is rounded or otherwise irregularly shaped, and the gate stack 104 may conform to the shape of the wire 136. In use, the tri-gate transistor 120 may form conducting channels on more than three "sides" of the wire 136, potentially improving performance relative to tri-gate transistors. Although FIGS. 11A and 11B depict an embodiment in which the longitudinal axis of the wire 136 runs substantially parallel to a plane of the oxide material 130 (and a plane of the support 134), this need not be the case; in other embodiments, for example, the wire 136 may be oriented "vertically" so as to be perpendicular to a plane of the oxide material 130 (or plane of the support 134).

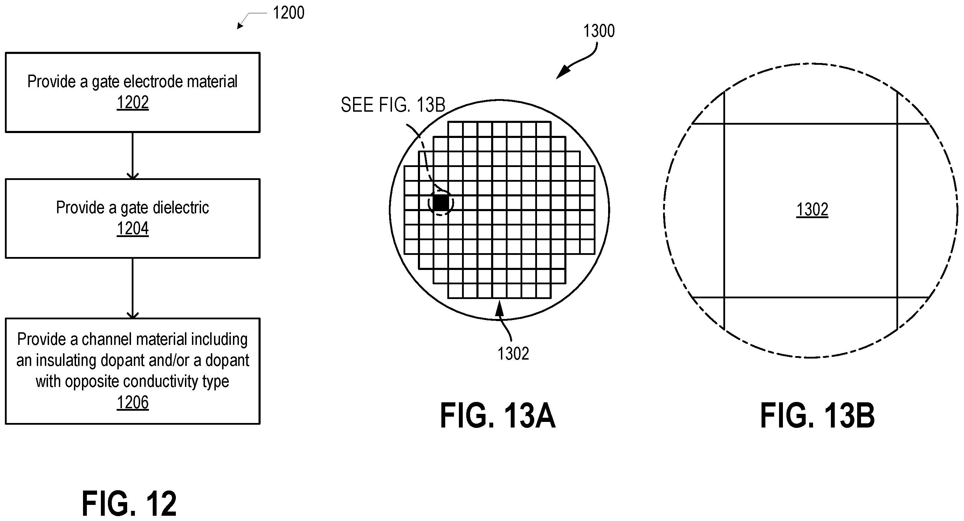

The IC structures 100 disclosed herein may be manufactured using any suitable techniques. For example, FIG. 12 is a flow diagram of an example method 1200 of manufacturing an IC structure including a doped channel material, in accordance with various embodiments. Although the operations of the method 1200 are illustrated once each and in a particular order, the operations may be performed in any suitable order and repeated as desired. For example, one or more operations may be performed in parallel to manufacture multiple transistor gate stacks substantially simultaneously. In another example, the operations may be performed in a different order to reflect the structure of a transistor in which the transistor gate stack will be included (e.g., the gate electrode material 108 of the transistor 120 of FIG. 5 may be provided before the gate dielectric 106, while the gate electrode material 108 of the transistor 120 of FIG. 10 may be provided after the gate dielectric 106).

At 1202, a gate electrode material may be provided. The gate electrode material provided at 1202 may take the form of any of the embodiments of the gate electrode material 108 disclosed herein, for example (e.g., any of the embodiments discussed herein with reference to a transistor 120). The gate electrode material may be provided at 1202 using any suitable deposition and patterning technique known in the art.

At 1204, a gate dielectric may be provided. The gate dielectric provided at 1204 may take the form of any of the embodiments of the gate dielectric 106 disclosed herein, for example. In some embodiments, the gate dielectric may be provided at 1204 so as to be in contact with the gate electrode material of 1202. In other embodiments, an intermediate material may be disposed between the gate electrode material and the gate dielectric. The gate dielectric may be provided at 1204 using any suitable technique known in the art.

At 1206, a channel material may be provided that includes an insulating dopant and/or a dopant with an opposite conductivity type to a semiconductor of the channel. At 1206, the channel material may be provided such that the gate dielectric is disposed between the channel material and the gate electrode material. The channel material provided at 1206 may take the form of any of the embodiments of the doped channel material 102 disclosed herein.

The method 1200 may further include other manufacturing operations related to fabrication of other components of a transistor 120. For example, the method 1200 may include providing S/D contacts (e.g., in accordance with any suitable ones of the embodiments discussed above).

The doped channel materials 102 disclosed herein may be included in any suitable electronic device. FIGS. 13-16 illustrate various examples of apparatuses that may include one or more of the doped channel materials 102 disclosed herein.

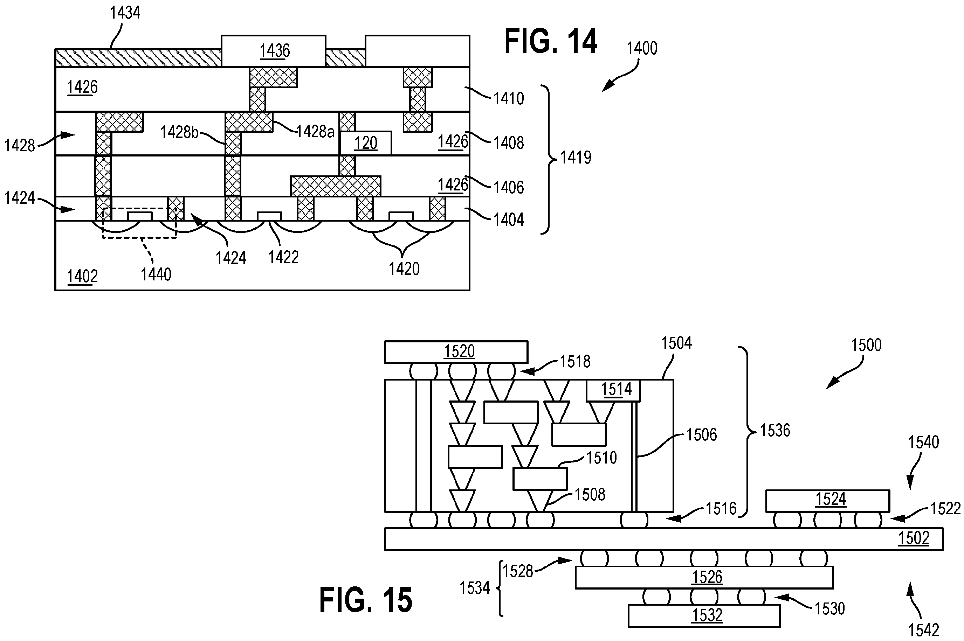

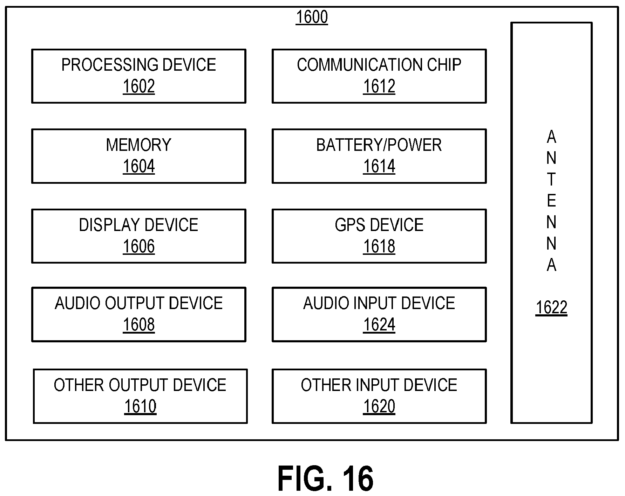

FIGS. 13A-B are top views of a wafer 1300 and dies 1302 that may include one or more doped channel materials 102 in accordance with any of the embodiments disclosed herein. The wafer 1300 may be composed of semiconductor material and may include one or more dies 1302 having IC structures formed on a surface of the wafer 1300. Each of the dies 1302 may be a repeating unit of a semiconductor product that includes any suitable IC (e.g., ICs including one or more transistors 120 that include one or more doped channel materials 102). After the fabrication of the semiconductor product is complete (e.g., after manufacture of a doped channel material 102 in a transistor 120), the wafer 1300 may undergo a singulation process in which the dies 1302 are separated from one another to provide discrete "chips" of the semiconductor product. In particular, devices that include a doped channel material 102 as disclosed herein may take the form of the wafer 1300 (e.g., not singulated) or the form of the die 1302 (e.g., singulated). The die 1302 may include one or more transistors (e.g., one or more of the transistors 1440 of FIG. 14, discussed below, which may take the form of any of the transistors 120) and/or supporting circuitry to route electrical signals to the transistors, as well as any other IC components. In some embodiments, the wafer 1300 or the die 1302 may include a memory device (e.g., a static random access memory (SRAM) device), a logic device (e.g., an AND, OR, NAND, or NOR gate), or any other suitable circuit element. Multiple ones of these devices may be combined on a single die 1302. For example, a memory array formed by multiple memory devices may be formed on a same die 1302 as a processing device (e.g., the processing device 1602 of FIG. 16) or other logic that is configured to store information in the memory devices or execute instructions stored in the memory array.

FIG. 14 is a cross-sectional side view of an IC device 1400 that may include one or more doped channel materials 102 in accordance with any of the embodiments disclosed herein. The IC device 1400 may be formed on a substrate 1402 (e.g., the wafer 1300 of FIG. 13A) and may be included in a die (e.g., the die 1302 of FIG. 13B). The substrate 1402 may be a semiconductor substrate composed of semiconductor material systems including, for example, n-type or p-type materials systems. The substrate 1402 may include, for example, a crystalline substrate formed using a bulk silicon or a silicon-on-insulator substructure. In some embodiments, the semiconductor substrate 1402 may be formed using alternative materials, which may or may not be combined with silicon, that include, but are not limited to, germanium, indium antimonide, lead telluride, indium arsenide, indium phosphide, gallium arsenide, or gallium antimonide. Further materials classified as group II-VI, III-V, or IV may also be used to form the substrate 1402. Although a few examples of materials from which the substrate 1402 may be formed are described here, any material that may serve as a foundation for an IC device 1400 may be used. The substrate 1402 may be part of a singulated die (e.g., the dies 1302 of FIG. 13B) or a wafer (e.g., the wafer 1300 of FIG. 13A).

The IC device 1400 may include one or more device layers 1404 disposed on the substrate 1402. The device layer 1404 may include features of one or more transistors 1440 (e.g., metal oxide semiconductor field-effect transistors (MOSFETs)) formed on the substrate 1402. The device layer 1404 may include, for example, one or more source and/or drain (S/D) regions 1420, a gate 1422 to control current flow in the transistors 1440 between the S/D regions 1420, and one or more S/D contacts 1424 to route electrical signals to/from the S/D regions 1420. The transistors 1440 may include additional features not depicted for the sake of clarity, such as device isolation regions, gate contacts, and the like. The transistors 1440 are not limited to the type and configuration depicted in FIG. 14 and may include a wide variety of other types and configurations such as, for example, planar transistors, non-planar transistors, or a combination of both. Non-planar transistors may include FinFET transistors, such as double-gate transistors or tri-gate transistors, and wrap-around or all-around gate transistors, such as nanoribbon and nanowire transistors. In particular, one or more of the transistors 1440 may include one or more doped channel materials 102 in accordance with any of the embodiments disclosed herein. Thin-film transistors 120 including the doped channel materials 102 disclosed herein may be particularly advantageous when used in the metal layers of a microprocessor device for analog circuitry, logic circuitry, or memory circuitry, and may be formed along with existing complementary metal oxide semiconductor (CMOS) processes; a single "back-end" transistor 120 is depicted in the metallization stack 1419 of the IC device 1400 for ease of illustration, but the transistors 120 disclosed herein may be included in any suitable number, location, and arrangement in an IC device 1400.

Each transistor 1440 may include a gate 1422 formed of at least two layers, a gate dielectric layer and a gate electrode layer. The gate electrode layer may take the form of any of the embodiments of the gate electrode material 108 disclosed herein. Generally, the gate dielectric layer of a transistor 1440 may include one layer or a stack of layers, and the one or more layers may include silicon oxide, silicon dioxide, and/or a high-k dielectric material. The high-k dielectric material included in the gate dielectric layer of the transistor 1440 may take the form of any of the embodiments of the gate dielectric 106 disclosed herein, for example.

In some embodiments, when viewed as a cross section of the transistor 1440 along the source-channel-drain direction, the gate electrode may consist of a U-shaped structure that includes a bottom portion substantially parallel to the surface of the substrate and two sidewall portions that are substantially perpendicular to the top surface of the substrate (e.g., as discussed above with reference to the tri-gate transistor 120 of FIGS. 10A and 10B). In other embodiments, at least one of the metal layers that form the gate electrode may simply be a planar layer that is substantially parallel to the top surface of the substrate and does not include sidewall portions substantially perpendicular to the top surface of the substrate. In other embodiments, the gate electrode may consist of a combination of U-shaped structures and planar, non-U-shaped structures. For example, the gate electrode may consist of one or more U-shaped metal layers formed atop one or more planar, non-U-shaped layers. In some embodiments, the gate electrode may consist of a V-shaped structure (e.g., when the fin 132 does not have a "flat" upper surface, but instead has a rounded peak).

In some embodiments, a pair of sidewall spacers may be formed on opposing sides of the gate stack to bracket the gate stack. The sidewall spacers may be formed from a material such as silicon nitride, silicon oxide, silicon carbide, silicon nitride doped with carbon, and silicon oxynitride. Processes for forming sidewall spacers are well known in the art and generally include deposition and etching process steps. In some embodiments, a plurality of spacer pairs may be used; for instance, two pairs, three pairs, or four pairs of sidewall spacers may be formed on opposing sides of the gate stack.

The S/D regions 1420 may be formed within the substrate 1402 adjacent to the gate 1422 of each transistor 1440. The S/D regions 1420 may take the form of any of the embodiments of the S/D contact 116 and the S/D contact 118 discussed above with reference to the transistors 120. In other embodiments, the S/D regions 1420 may be formed using any suitable processes known in the art. For example, the S/D regions 1420 may be formed using either an implantation/diffusion process or a deposition process. In the former process, dopants such as boron, aluminum, antimony, phosphorous, or arsenic may be ion-implanted into the substrate 1402 to form the S/D regions 1420. An annealing process that activates the dopants and causes them to diffuse farther into the substrate 1402 may follow the ion implantation process. In the latter process, an epitaxial deposition process may provide material that is used to fabricate the S/D regions 1420. In some implementations, the S/D regions 1420 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 1420 may be formed using one or more alternate semiconductor materials such as germanium or a group II I-V material or alloy. In further embodiments, one or more layers of metal and/or metal alloys may be used to form the S/D regions 1420 (e.g., as discussed above with reference to the S/D contact 116 and the S/D contact 118). In some embodiments, an etch process may be performed before the epitaxial deposition to create recesses in the substrate 1402 in which the material for the S/D regions 1420 is deposited.

Electrical signals, such as power and/or input/output (I/O) signals, may be routed to and/or from the transistors 1440 of the device layer 1404 through one or more interconnect layers disposed on the device layer 1404 (illustrated in FIG. 14 as interconnect layers 1406-1410). For example, electrically conductive features of the device layer 1404 (e.g., the gate 1422 and the S/D contacts 1424) may be electrically coupled with the interconnect structures 1428 of the interconnect layers 1406-1410. The one or more interconnect layers 1406-1410 may form a metallization stack 1419 of the IC device 1400.

The interconnect structures 1428 may be arranged within the interconnect layers 1406-1410 to route electrical signals according to a wide variety of designs (in particular, the arrangement is not limited to the particular configuration of interconnect structures 1428 depicted in FIG. 14). Although a particular number of interconnect layers 1406-1410 is depicted in FIG. 14, embodiments of the present disclosure include IC devices having more or fewer interconnect layers than depicted.

In some embodiments, the interconnect structures 1428 may include trench structures 1428a (sometimes referred to as "lines") and/or via structures 1428b (sometimes referred to as "holes") filled with an electrically conductive material such as a metal. The trench structures 1428a may be arranged to route electrical signals in a direction of a plane that is substantially parallel with a surface of the substrate 1402 upon which the device layer 1404 is formed. For example, the trench structures 1428a may route electrical signals in a direction in and out of the page from the perspective of FIG. 14. The via structures 1428b may be arranged to route electrical signals in a direction of a plane that is substantially perpendicular to the surface of the substrate 1402 upon which the device layer 1404 is formed. In some embodiments, the via structures 1428b may electrically couple trench structures 1428a of different interconnect layers 1406-1410 together.

The interconnect layers 1406-1410 may include a dielectric material 1426 disposed between the interconnect structures 1428, as shown in FIG. 14. In some embodiments, the dielectric material 1426 disposed between the interconnect structures 1428 in different ones of the interconnect layers 1406-1410 may have different compositions; in other embodiments, the composition of the dielectric material 1426 between different interconnect layers 1406-1410 may be the same.

A first interconnect layer 1406 (referred to as Metal 1 or "M1") may be formed directly on the device layer 1404. In some embodiments, the first interconnect layer 1406 may include trench structures 1428a and/or via structures 1428b, as shown. The trench structures 1428a of the first interconnect layer 1406 may be coupled with contacts (e.g., the S/D contacts 1424) of the device layer 1404.

A second interconnect layer 1408 (referred to as Metal 2 or "M2") may be formed directly on the first interconnect layer 1406. In some embodiments, the second interconnect layer 1408 may include via structures 1428b to couple the trench structures 1428a of the second interconnect layer 1408 with the trench structures 1428a of the first interconnect layer 1406. Although the trench structures 1428a and the via structures 1428b are structurally delineated with a line within each interconnect layer (e.g., within the second interconnect layer 1408) for the sake of clarity, the trench structures 1428a and the via structures 1428b may be structurally and/or materially contiguous (e.g., simultaneously filled during a dual-damascene process) in some embodiments.

A third interconnect layer 1410 (referred to as Metal 3 or "M3") (and additional interconnect layers, as desired) may be formed in succession on the second interconnect layer 1408 according to similar techniques and configurations described in connection with the second interconnect layer 1408 or the first interconnect layer 1406.

The IC device 1400 may include a solder resist material 1434 (e.g., polyimide or similar material) and one or more bond pads 1436 formed on the interconnect layers 1406-1410. The bond pads 1436 may be electrically coupled with the interconnect structures 1428 and configured to route the electrical signals of the transistor(s) 1440 to other external devices. For example, solder bonds may be formed on the one or more bond pads 1436 to mechanically and/or electrically couple a chip including the IC device 1400 with another component (e.g., a circuit board). The IC device 1400 may have other alternative configurations to route the electrical signals from the interconnect layers 1406-1410 than depicted in other embodiments. For example, the bond pads 1436 may be replaced by or may further include other analogous features (e.g., posts) that route the electrical signals to external components.

FIG. 15 is a cross-sectional side view of an IC device assembly 1500 that may include components having one or more doped channel materials 102 in accordance with any of the embodiments disclosed herein. The IC device assembly 1500 includes a number of components disposed on a circuit board 1502 (which may be, e.g., a motherboard). The IC device assembly 1500 includes components disposed on a first face 1540 of the circuit board 1502 and an opposing second face 1542 of the circuit board 1502; generally, components may be disposed on one or both faces 1540 and 1542. In particular, any suitable ones of the components of the IC device assembly 1500 may include any of the doped channel materials 102 disclosed herein (e.g., in any of the transistors 120 disclosed herein).

In some embodiments, the circuit board 1502 may be a printed circuit board (PCB) including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 1502. In other embodiments, the circuit board 1502 may be a non-PCB substrate.

The IC device assembly 1500 illustrated in FIG. 15 includes a package-on-interposer structure 1536 coupled to the first face 1540 of the circuit board 1502 by coupling components 1516. The coupling components 1516 may electrically and mechanically couple the package-on-interposer structure 1536 to the circuit board 1502, and may include solder balls (as shown in FIG. 15), male and female portions of a socket, an adhesive, an underfill material, and/or any other suitable electrical and/or mechanical coupling structure.

The package-on-interposer structure 1536 may include an IC package 1520 coupled to an interposer 1504 by coupling components 1518. The coupling components 1518 may take any suitable form for the application, such as the forms discussed above with reference to the coupling components 1516. Although a single IC package 1520 is shown in FIG. 15, multiple IC packages may be coupled to the interposer 1504; indeed, additional interposers may be coupled to the interposer 1504. The interposer 1504 may provide an intervening substrate used to bridge the circuit board 1502 and the IC package 1520. The IC package 1520 may be or include, for example, a die (the die 1302 of FIG. 13B), an IC device (e.g., the IC device 1400 of FIG. 14), or any other suitable component. Generally, the interposer 1504 may spread a connection to a wider pitch or reroute a connection to a different connection. For example, the interposer 1504 may couple the IC package 1520 (e.g., a die) to a ball grid array (BGA) of the coupling components 1516 for coupling to the circuit board 1502. In the embodiment illustrated in FIG. 15, the IC package 1520 and the circuit board 1502 are attached to opposing sides of the interposer 1504; in other embodiments, the IC package 1520 and the circuit board 1502 may be attached to a same side of the interposer 1504. In some embodiments, three or more components may be interconnected by way of the interposer 1504.

The interposer 1504 may be formed of an epoxy resin, a fiberglass-reinforced epoxy resin, a ceramic material, or a polymer material such as polyimide. In some implementations, the interposer 1504 may be formed of alternate rigid or flexible materials that may include the same materials described above for use in a semiconductor substrate, such as silicon, germanium, and other group III-V and group IV materials. The interposer 1504 may include metal interconnects 1508 and vias 1510, including but not limited to through-silicon vias (TSVs) 1506. The interposer 1504 may further include embedded devices 1514, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio-frequency (RF) devices, power amplifiers, power management devices, antennas, arrays, sensors, and microelectromechanical systems (MEMS) devices may also be formed on the interposer 1504. The package-on-interposer structure 1536 may take the form of any of the package-on-interposer structures known in the art.

The IC device assembly 1500 may include an IC package 1524 coupled to the first face 1540 of the circuit board 1502 by coupling components 1522. The coupling components 1522 may take the form of any of the embodiments discussed above with reference to the coupling components 1516, and the IC package 1524 may take the form of any of the embodiments discussed above with reference to the IC package 1520.

The IC device assembly 1500 illustrated in FIG. 15 includes a package-on-package structure 1534 coupled to the second face 1542 of the circuit board 1502 by coupling components 1528. The package-on-package structure 1534 may include an IC package 1526 and an IC package 1532 coupled together by coupling components 1530 such that the IC package 1526 is disposed between the circuit board 1502 and the IC package 1532. The coupling components 1528 and 1530 may take the form of any of the embodiments of the coupling components 1516 discussed above, and the IC packages 1526 and 1532 may take the form of any of the embodiments of the IC package 1520 discussed above. The package-on-package structure 1534 may be configured in accordance with any of the package-on-package structures known in the art.

FIG. 16 is a block diagram of an example computing device 1600 that may include one or more components including one or more doped channel materials 102 in accordance with any of the embodiments disclosed herein. For example, any suitable ones of the components of the computing device 1600 may include a die (e.g., the die 1302 (FIG. 13B)) having one or more transistors 120 including one or more doped channel materials 102. Any one or more of the components of the computing device 1600 may include, or be included in, an IC device 1400 (FIG. 14). Any one or more of the components of the computing device 1600 may include, or be included in, an IC device assembly 1500 (FIG. 15).

A number of components are illustrated in FIG. 16 as included in the computing device 1600, but any one or more of these components may be omitted or duplicated, as suitable for the application. In some embodiments, some or all of the components included in the computing device 1600 may be attached to one or more motherboards. In some embodiments, some or all of these components are fabricated onto a single system-on-a-chip (SoC) die.

Additionally, in various embodiments, the computing device 1600 may not include one or more of the components illustrated in FIG. 16, but the computing device 1600 may include interface circuitry for coupling to the one or more components. For example, the computing device 1600 may not include a display device 1606, but may include display device interface circuitry (e.g., a connector and driver circuitry) to which a display device 1606 may be coupled. In another set of examples, the computing device 1600 may not include an audio input device 1624 or an audio output device 1608, but may include audio input or output device interface circuitry (e.g., connectors and supporting circuitry) to which an audio input device 1624 or audio output device 1608 may be coupled.

The computing device 1600 may include a processing device 1602 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 1602 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices. The computing device 1600 may include a memory 1604, which may itself include one or more memory devices such as volatile memory (e.g., dynamic random access memory (DRAM)), nonvolatile memory (e.g., read-only memory (ROM)), flash memory, solid state memory, and/or a hard drive. In some embodiments, the memory 1604 may include memory that shares a die with the processing device 1602. This memory may be used as cache memory and may include embedded dynamic random access memory (eDRAM) or spin transfer torque magnetic random-access memory (STT-MRAM).

In some embodiments, the computing device 1600 may include a communication chip 1612 (e.g., one or more communication chips). For example, the communication chip 1612 may be configured for managing wireless communications for the transfer of data to and from the computing device 1600. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 1612 may implement any of a number of wireless standards or protocols, including but not limited to Institute for Electrical and Electronic Engineers (IEEE) standards including Wi-Fi (IEEE 1402.11 family), IEEE 1402.16 standards (e.g., IEEE 1402.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 1402.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 1402.16 standards. The communication chip 1612 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 1612 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 1612 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 1612 may operate in accordance with other wireless protocols in other embodiments. The computing device 1600 may include an antenna 1622 to facilitate wireless communications and/or to receive other wireless communications (such as AM or FM radio transmissions).

In some embodiments, the communication chip 1612 may manage wired communications, such as electrical, optical, or any other suitable communication protocols (e.g., the Ethernet). As noted above, the communication chip 1612 may include multiple communication chips. For instance, a first communication chip 1612 may be dedicated to shorter-range wireless communications such as Wi-Fi or Bluetooth, and a second communication chip 1612 may be dedicated to longer-range wireless communications such as global positioning system (GPS), EDGE, GPRS, CDMA, WiMAX, LTE, EV-DO, or others. In some embodiments, a first communication chip 1612 may be dedicated to wireless communications, and a second communication chip 1612 may be dedicated to wired communications.

The computing device 1600 may include battery/power circuitry 1614. The battery/power circuitry 1614 may include one or more energy storage devices (e.g., batteries or capacitors) and/or circuitry for coupling components of the computing device 1600 to an energy source separate from the computing device 1600 (e.g., AC line power).

The computing device 1600 may include a display device 1606 (or corresponding interface circuitry, as discussed above). The display device 1606 may include any visual indicators, such as a heads-up display, a computer monitor, a projector, a touchscreen display, a liquid crystal display (LCD), a light-emitting diode display, or a flat panel display, for example.

The computing device 1600 may include an audio output device 1608 (or corresponding interface circuitry, as discussed above). The audio output device 1608 may include any device that generates an audible indicator, such as speakers, headsets, or earbuds, for example.

The computing device 1600 may include an audio input device 1624 (or corresponding interface circuitry, as discussed above). The audio input device 1624 may include any device that generates a signal representative of a sound, such as microphones, microphone arrays, or digital instruments (e.g., instruments having a musical instrument digital interface (MIDI) output).

The computing device 1600 may include a GPS device 1618 (or corresponding interface circuitry, as discussed above). The GPS device 1618 may be in communication with a satellite-based system and may receive a location of the computing device 1600, as known in the art.

The computing device 1600 may include an other output device 1610 (or corresponding interface circuitry, as discussed above). Examples of the other output device 1610 may include an audio codec, a video codec, a printer, a wired or wireless transmitter for providing information to other devices, or an additional storage device.

The computing device 1600 may include an other input device 1620 (or corresponding interface circuitry, as discussed above). Examples of the other input device 1620 may include an accelerometer, a gyroscope, a compass, an image capture device, a keyboard, a cursor control device such as a mouse, a stylus, a touchpad, a bar code reader, a Quick Response (QR) code reader, any sensor, or an RF identification (RFID) reader.

The computing device 1600 may have any desired form factor, such as a handheld or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device. In some embodiments, the computing device 1600 may be any other electronic device that processes data.

The following paragraphs provide various examples of the embodiments disclosed herein.
Example 1 is a transistor, including: a gate electrode material; a gate dielectric material; and a channel material, wherein the gate dielectric material is between the channel material and the gate electrode material, the channel material includes a semiconductor material having a first conductivity type, and the channel material further includes a dopant including (1) an insulating material or (2) a material having a second conductivity type opposite to the first conductivity type.
Example 2 includes the subject matter of Example 1, and further specifies that the dopant includes an insulating material.
Example 3 includes the subject matter of Example 2, and further specifies that the insulating material includes aluminum and oxygen; hafnium and oxygen; titanium and oxygen; aluminum and nitrogen; silicon and nitrogen; silicon and oxygen; silicon, carbon, oxygen, and hydrogen; tantalum and oxygen; yttrium and oxygen; gallium and oxygen; zirconium and oxygen; hafnium, zirconium, and oxygen; yttrium, zirconium, and oxygen; magnesium and oxygen; or carbon.
Example 4 includes the subject matter of any of Examples 2-3, and further specifies that the insulating material includes aluminum oxide, hafnium oxide, titanium oxide, aluminum nitride, silicon nitride, silicon oxide, organosilicate glass; tantalum oxide; yttrium oxide; gallium oxide; zirconium oxide; hafnium zirconium oxide; yttrium zirconium oxide; magnesium oxide; or carbon.
Example 5 includes the subject matter of any of Examples 1-4, and further specifies that the semiconductor material includes indium, gallium, zinc, and oxygen; indium, tin, and oxygen; indium and oxygen; or zinc and oxygen.
Example 6 includes the subject matter of any of Examples 1-5, and further specifies that the semiconductor material includes indium gallium zinc oxide; indium tin oxide; indium oxide; or zinc oxide.
Example 7 includes the subject matter of any of Examples 1-6, and further specifies that the dopant includes copper and oxygen; tin and oxygen; niobium and oxygen; nickel and oxygen; or cobalt and oxygen.
Example 8 includes the subject matter of any of Examples 1-7, and further specifies that the dopant includes copper oxide; tin oxide; niobium oxide; nickel oxide; or cobalt oxide.
Example 9 includes the subject matter of any of Examples 1-4, and further specifies that the channel material includes a dopant including a material having a second conductivity type opposite to the first conductivity type, the first conductivity type is n-type and the second conductivity type is p-type.
Example 10 includes the subject matter of any of Examples 1-4, and further specifies that the channel material includes a dopant including a material having a second conductivity type opposite to the first conductivity type, the first conductivity type is p-type and the second conductivity type is n-type.
Example 11 includes the subject matter of any of Examples 1-10, and further specifies that the dopant is a first dopant, the first dopant includes an insulating material, the channel material includes a second dopant, and the second dopant has a second conductivity type opposite to the first conductivity type.
Example 12 includes the subject matter of any of Examples 1-11, and further specifies that the semiconductor material includes a group IV semiconductor.
Example 13 includes the subject matter of any of Examples 1-12, and further specifies that the semiconductor material includes a group III-V semiconductor.
Example 14 includes the subject matter of any of Examples 1-13, and further specifies that the semiconductor material includes an oxide semiconductor.
Example 15 includes the subject matter of Example 14, and further specifies that the oxide semiconductor includes indium, zinc, and oxygen; indium, gallium, zinc, and oxygen; indium, tin, and oxygen; indium and oxygen; zinc and oxygen; tin and oxygen; or copper and oxygen.
Example 16 includes the subject matter of any of Examples 14-15, and further specifies that the oxide semiconductor includes indium zinc oxide, indium gallium zinc oxide, indium tin oxide, indium oxide, zinc oxide, tin oxide, or copper oxide.
Example 17 includes the subject matter of any of Examples 1-16, and further specifies that an amount of the dopant in the semiconductor material is less than 10 atomic-percent.
Example 18 includes the subject matter of any of Examples 1-17, and further specifies that the channel material is a first channel material region, the transistor includes a second channel material region, and the second channel material region includes the semiconductor material.
Example 19 includes the subject matter of Example 18, and further specifies that the second channel material region does not include the dopant.
Example 20 includes the subject matter of any of Examples 18-19, and further specifies that the first channel material region is between the second channel material region and a dielectric material.
Example 21 includes the subject matter of Example 20, and further specifies that the dielectric material includes a passivation material.
Example 22 includes the subject matter of any of Examples 1-21, and further specifies that the transistor is a top contact transistor.
Example 23 includes the subject matter of any of Examples 1-21, and further specifies that the transistor is a bottom contact transistor.
Example 24 includes the subject matter of any of Examples 1-23, and further specifies that the transistor is a top gate transistor.
Example 25 includes the subject matter of any of Examples 1-23, and further specifies that the transistor is a bottom gate transistor.
Example 26 includes the subject matter of any of Examples 1-21, and further specifies that the channel material is shaped as a fin, and the gate dielectric wraps around the fin.
Example 27 includes the subject matter of any of Examples 1-21, and further specifies that the channel material is shaped as a wire, and the gate dielectric wraps around the wire.
Example 28 includes the subject matter of Example 27, and further specifies that the gate dielectric wraps entirely around the wire.
Example 29 is a transistor, including: a gate electrode material; a gate dielectric material; and a channel material, wherein the gate dielectric material is between the channel material and the gate electrode material, the channel material includes an oxide semiconductor having a first conductivity type, and the channel material further includes a dopant including (1) an insulating material or (2) a material having a second conductivity type opposite to the first conductivity type.
Example 30 includes the subject matter of Example 29, and further specifies that the dopant includes an insulating material.
Example 31 includes the subject matter of Example 30, and further specifies that the insulating material includes aluminum and oxygen; hafnium and oxygen; titanium and oxygen; aluminum and nitrogen; silicon and nitrogen; silicon and oxygen; silicon, carbon, oxygen, and hydrogen; tantalum and oxygen; yttrium and oxygen; gallium and oxygen; zirconium and oxygen; hafnium, zirconium, and oxygen; yttrium, zirconium, and oxygen; magnesium and oxygen; or carbon.
Example 32 includes the subject matter of any of Examples 30-31, and further specifies that the insulating material includes aluminum oxide, hafnium oxide, titanium oxide, aluminum nitride, silicon nitride, silicon oxide, organosilicate glass; tantalum oxide; yttrium oxide; gallium oxide; zirconium oxide; hafnium zirconium oxide; yttrium zirconium oxide; magnesium oxide; or carbon.
Example 33 includes the subject matter of any of Examples 29-32, and further specifies that the oxide semiconductor includes indium, gallium, zinc, and oxygen; indium, tin, and oxygen; indium and oxygen; or zinc and oxygen.
Example 34 includes the subject matter of any of Examples 29-33, and further specifies that the oxide semiconductor includes indium gallium zinc oxide; indium tin oxide; indium oxide; or zinc oxide.
Example 35 includes the subject matter of any of Examples 29-34, and further specifies that the dopant includes copper and oxygen; tin and oxygen; niobium and oxygen; nickel and oxygen; or cobalt and oxygen.
Example 36 includes the subject matter of any of Examples 29-35, and further specifies that the dopant includes copper oxide; tin oxide; niobium oxide; nickel oxide; or cobalt oxide.
Example 37 includes the subject matter of any of Examples 29-32, and further specifies that the channel material includes a dopant including a material having a second conductivity type opposite to the first conductivity type, the first conductivity type is n-type and the second conductivity type is p-type.
Example 38 includes the subject matter of any of Examples 29-32, and further specifies that the channel material includes a dopant including a material having a second conductivity type opposite to the first conductivity type, the first conductivity type is p-type and the second conductivity type is n-type.
Example 39 includes the subject matter of any of Examples 29-38, and further specifies that the dopant is a first dopant, the first dopant includes an insulating material, the channel material includes a second dopant, and the second dopant has a second conductivity type opposite to the first conductivity type.
Example 40 includes the subject matter of any of Examples 29-39, and further specifies that an amount of the dopant in the oxide semiconductor is less than 10 atomic-percent.
Example 41 includes the subject matter of any of Examples 29-40, and further specifies that the channel material is a first channel material region, the transistor includes a second channel material region, and the second channel material region includes the oxide semiconductor.
Example 42 includes the subject matter of Example 41, and further specifies that the second channel material region does not include the dopant.
Example 43 includes the subject matter of any of Examples 41-42, and further specifies that the first channel material region is between the second channel material region and a dielectric material.
Example 44 includes the subject matter of Example 43, and further specifies that the dielectric material includes a passivation material.
Example 45 includes the subject matter of any of Examples 29-44, and further specifies that the transistor is a top contact transistor.
Example 46 includes the subject matter of any of Examples 29-44, and further specifies that the transistor is a bottom contact transistor.
Example 47 includes the subject matter of any of Examples 29-46, and further specifies that the transistor is a top gate transistor.
Example 48 includes the subject matter of any of Examples 29-46, and further specifies that the transistor is a bottom gate transistor.
Example 49 includes the subject matter of any of Examples 29-44, and further specifies that the channel material is shaped as a fin, and the gate dielectric wraps around the fin.
Example 50 includes the subject matter of any of Examples 29-44, and further specifies that the channel material is shaped as a wire, and the gate dielectric wraps around the wire.
Example 51 includes the subject matter of Example 50, and further specifies that the gate dielectric wraps entirely around the wire.
Example 52 is a transistor, including: a gate electrode material; a gate dielectric material; and a channel material, wherein the gate dielectric material is between the channel material and the gate electrode material, the channel material includes a first layer of a first semiconductor material including a first dopant including an insulating material, and the channel material includes a second layer of a second semiconductor material having a first conductivity type, and the second layer further includes a second dopant including a material having a second conductivity type opposite to the first conductivity type.
Example 53 includes the subject matter of Example 52, and further specifies that the insulating material includes aluminum and oxygen; hafnium and oxygen; titanium and oxygen; aluminum and nitrogen; silicon and nitrogen; silicon and oxygen; silicon, carbon, oxygen, and hydrogen; tantalum and oxygen; yttrium and oxygen; gallium and oxygen; zirconium and oxygen; hafnium, zirconium, and oxygen; yttrium, zirconium, and oxygen; magnesium and oxygen; or carbon.
Example 54 includes the subject matter of any of Examples 52-53, and further specifies that the insulating material includes aluminum oxide, hafnium oxide, titanium oxide, aluminum nitride, silicon nitride, silicon oxide, organosilicate glass; tantalum oxide; yttrium oxide; gallium oxide; zirconium oxide; hafnium zirconium oxide; yttrium zirconium oxide; magnesium oxide; or carbon.
Example 55 includes the subject matter of any of Examples 52-54, and further specifies that the second semiconductor material includes indium, gallium, zinc, and oxygen; indium, tin, and oxygen; indium and oxygen; or zinc and oxygen.
Example 56 includes the subject matter of any of Examples 52-55, and further specifies that the second semiconductor material includes indium gallium zinc oxide; indium tin oxide; indium oxide; or zinc oxide.
Example 57 includes the subject matter of any of Examples 52-56, and further specifies that the second dopant includes copper and oxygen; tin and oxygen; niobium and oxygen; nickel and oxygen; or cobalt and oxygen.
Example 58 includes the subject matter of any of Examples 52-57, and further specifies that the second dopant includes copper oxide; tin oxide; niobium oxide; nickel oxide; or cobalt oxide.
Example 59 includes the subject matter of any of Examples 52-54, and further specifies that the first conductivity type is n-type and the second conductivity type is p-type.
Example 60 includes the subject matter of any of Examples 52-54, and further specifies that the first conductivity type is p-type and the second conductivity type is n-type.
Example 61 includes the subject matter of any of Examples 52-60, and further specifies that the gate dielectric material includes a high-k material.
Example 62 includes the subject matter of any of Examples 52-61, and further specifies that the first semiconductor material or the second semiconductor material includes a group IV semiconductor.
Example 63 includes the subject matter of any of Examples 52-62, and further specifies that the first semiconductor material or the second semiconductor material includes a group III-V semiconductor.
Example 64 includes the subject matter of any of Examples 52-63, and further specifies that the first semiconductor material or the second semiconductor material includes an oxide semiconductor.
Example 65 includes the subject matter of Example 64, and further specifies that the oxide semiconductor includes indium, zinc, and oxygen; indium, gallium, zinc, and oxygen; indium, tin, and oxygen; indium and oxygen; zinc and oxygen; tin and oxygen; or copper and oxygen.
Example 66 includes the subject matter of any of Examples 64-65, and further specifies that the oxide semiconductor includes indium zinc oxide, indium gallium zinc oxide, indium tin oxide, indium oxide, zinc oxide, tin oxide, or copper oxide.
Example 67 includes the subject matter of any of Examples 52-66, and further specifies that an amount of the first dopant in the first semiconductor material is less than 10 atomic-percent.
Example 68 includes the subject matter of any of Examples 52-67, and further specifies that an amount of the second dopant in the second semiconductor material is less than 10 atomic-percent.
Example 69 includes the subject matter of any of Examples 52-68, and further specifies that the transistor is a top contact transistor.
Example 70 includes the subject matter of any of Examples 52-68, and further specifies that the transistor is a bottom contact transistor.
Example 71 includes the subject matter of any of Examples 52-70, and further specifies that the transistor is a top gate transistor.
Example 72 includes the subject matter of any of Examples 52-70, and further specifies that the transistor is a bottom gate transistor.
Example 73 includes the subject matter of any of Examples 52-68, and further specifies that the channel material is shaped as a fin, and the gate dielectric wraps around the fin.
Example 74 includes the subject matter of any of Examples 52-68, and further specifies that the channel material is shaped as a wire, and the gate dielectric wraps around the wire.
Example 75 includes the subject matter of Example 74, and further specifies that the gate dielectric wraps entirely around the wire.
Example 76 is a computing device, including: a substrate; and an integrated circuit (IC) die coupled to the substrate, wherein the IC die includes the transistor of any of Examples 1-75.
Example 77 includes the subject matter of Example 76, and further specifies that the computing device is a wearable or handheld computing device.
Example 78 includes the subject matter of any of Examples 76-77, and further specifies that the computing device further includes one or more communication chips and an antenna.
Example 79 includes the subject matter of any of Examples 76-78, and further specifies that the substrate includes a motherboard.
Example 80 includes the subject matter of any of Examples 76-79, and further specifies that the substrate includes a package substrate.

## Claims

1. A transistor, comprising:
a gate electrode material;
a gate dielectric material; and
a channel material, wherein the gate dielectric material is between the channel material and the gate electrode material, the channel material includes a semiconductor material having a first conductivity type, and the channel material further includes a dopant including (1) an insulating material or (2) a material having a second conductivity type opposite to the first conductivity type.

2. The transistor of claim 1, wherein the dopant includes an insulating material.

3. The transistor of claim 2, wherein the insulating material includes aluminum and oxygen; hafnium and oxygen; titanium and oxygen; aluminum and nitrogen; silicon and nitrogen; silicon and oxygen; silicon, carbon, oxygen, and hydrogen; tantalum and oxygen; yttrium and oxygen; gallium and oxygen; zirconium and oxygen; hafnium, zirconium, and oxygen; yttrium, zirconium, and oxygen; magnesium and oxygen; or carbon.

4. The transistor of any one of claims 1-3, wherein the dopant includes copper and oxygen; tin and oxygen; niobium and oxygen; nickel and oxygen; or cobalt and oxygen.

5. The transistor of any one of claims 1-3, wherein the channel material includes a dopant including a material having a second conductivity type opposite to the first conductivity type.

6. The transistor of any one of claims 1-5, wherein the dopant is a first dopant, the first dopant includes an insulating material, the channel material includes a second dopant, and the second dopant has a second conductivity type opposite to the first conductivity type.

7. The transistor of any one of claims 1-6, wherein the semiconductor material includes a group IV semiconductor or a group III-V semiconductor.

8. The transistor of any one of claims 1-7, wherein the semiconductor material includes an oxide semiconductor.

9. The transistor of claim 8, wherein the oxide semiconductor includes indium, zinc, and oxygen; indium, gallium, zinc, and oxygen; indium, tin, and oxygen; indium and oxygen; zinc and oxygen; tin and oxygen; or copper and oxygen.

10. The transistor of claims 8 or 9, wherein the oxide semiconductor includes indium zinc oxide, indium gallium zinc oxide, indium tin oxide, indium oxide, zinc oxide, tin oxide, or copper oxide.

11. The transistor of any one of claims 1-10, wherein an amount of the dopant in the semiconductor material is less than 10 atomic-percent.

12. The transistor of any one of claims 1-11, wherein the channel material is a first channel material region, the transistor includes a second channel material region, and the second channel material region includes the semiconductor material.

13. The transistor of claim 12, wherein the second channel material region does not include the dopant.

14. The transistor of claims 12 or 13, wherein the first channel material region is between the second channel material region and a dielectric material.

15. The transistor of claim 14, wherein the dielectric material includes a passivation material.
